# EUROPEAN PATENT SPECIFICATION

(11) **EP 2 514 720 B1**
(45) Date of publication and mention of the grant of the patent: **04.05.2016**
(21) Application number: 11830091.2
(22) Date of filing: 30.05.2011
(51) Int. Cl.: C01G 9/03, C23C 16/40, C30B 25/02, H01L 21/365, C30B 25/00, C30B 29/16, C23C 16/455, H01L 21/02

(54) **PREPARATION METHOD OF HIGH DENSITY ZINC OXIDE NANOMETER GRANULES**
HERSTELLUNGSVERFAHREN FÜR ZNO-NANOPUNKTE VON HOHER DICHTE
PROCÉDÉ DE PRÉPARATION DE GRANULÉS D'OXYDE DE ZINC HAUTE DENSITÉ DE DIMENSION NANOMÉTRIQUE

(30) Priority: 02.03.2011 CN 201110049417; 27.05.2011 CN 201110139316
(43) Date of publication of application: 24.10.2012
(73) Proprietor: Fudan University, Yangpu, Shanghai 200433 (CN)
(72) Inventor: DING, Shijin, Shanghai, 200433 (CN); QIAN, Kejia, Shanghai, 200433 (CN); ZHANG, Wei, Shanghai, 200433 (CN)
(74) Representative: Tombling, Adrian George
(86) International application number: PCT/CN2011/000912
(87) International publication number: WO 2012/116477

(56) References cited:
- CN-A- 1 347 561
- CN-A- 1 389 910
- CN-A- 101 060 077
- CN-A- 101 170 068
- CN-A- 101 170 068
- US-A1- 2004 266 217
- US-A1- 2008 296 567
- US-A1- 2009 315 016
- US-A1- 2011 043 037

## Description

### Field of Invention

The invention relates to a method for preparing high density ZnO nanodots for high efficient solar cells or photoelectric conversion devices.

### Background of Invention

With development of nanometer integrated circuit manufacturing technology, a lot of processes can be used not only for the large scale integrated circuits but also for the other fields. In terms of the photovoltaic device application, ZnO is a type of semiconductor material with a wide band gap (3.37eV at room temperature) and a large exciton binding energy (60 meV), and exhibits high transparency in the visible wavelength, thus ZnO has vast prospects for photoelectric devices. Different from the bulk materials in which strong impact ionization exists, multiple electron-hole pairs can be generated from absorption of a photon in semiconductor nanodots, which can lead to the higher absorption efficiency in the visible spectral region. This high efficient "multiple exciton generation" in semiconductor nanodots can be widely applied in photovoltaic and photoelctrochemical cells. Therefore, ZnO nanodots have vast and practical prospects as a type of semiconductor material.

To obtain ZnO nanodots, a lot of methods have been introduced, such as chemical synthesis, ion implantation, molecular beam epitaxy and magnetron sputtering etc. However, all of these methods have not been employed for the practical applications due to either too complicate or too expensive. As far as we know, the chemical synthesis method has been widely reported to form ZnO nanopowder, but this type of ZnO nanodots still encounters many restrictions in practical applications. In addition, the methods of ion implantation, molecular beam epitaxy and magnetron sputtering have also been reported to embed the ZnO nanodots into some materials, for instance, SiO₂, whereas these methods usually require some post-treatments such as annealing, thus suffering from high thermal budgets and higher costs.

CN 101 170 068 A is directed to a method of manufacturing a ZnO buffer layer on a substrate. US2008/296567 A1 discloses a method of making a thin film transistor comprising a zinc-oxide-containing semiconductor material and spaced apart first and second electrodes in contact with the material. US2004/266217 A1 discloses a method of forming a high dielectric film using atomic layer deposition (ALD), and a method of manufacturing a capacitor having the high dielectric film.

Atomic layer deposition (ALD) is a new deposition technology with the advantages of self-limiting surface reaction, low temperature processing, excellent uniformity and conformality, precise thickness control, and good compatibility with integrated circuit manufacturing technology. Owing to the above mentioned advantages, ALD technology has been widely used for the deposition of metal, oxide and nitride thin films and nanodots. In recent years, there are many reports about the ALD growth of ZnO thin films. However, there is no public report about the ALD growth of ZnO nanodots. Compared with bulk ZnO where strong impact ionization exists, ZnO nanodots have higher excitation efficiency, because a single photon excition can generate multiple electron-hole pairs. Therefore, ZnO nanodots can lead to high efficient solar radiant energy conversion for the optoelectronic devices.

### Summary of the Invention

The present invention is to provide a preparation method of high density ZnO nanodots with uniform height distribution, which is used for high efficient solar cells or photoelectric conversion devices with the advantages of simple process, easy processing control and good compatibility.

In order to achieve the above mentioned purposes, the present invention provides a preparation method of high density ZnO nanodots. The method adopts inert gas diluted gaseous diethylzinc (DEZn) and H₂O₂ vapor as reactive precursors, and uses ALD technology to grow high density ZnO nanodots. Wherein, the said gaseous DEZn and H₂O₂ vapor are alternately pulsed into the reaction chamber, and the inert gas is introduced into the reaction chamber as purge gas during an interval between the two precursors pulses.

The above mentioned preparation method of high density ZnO nanodots, wherein, said inert gas is the gas that does not react with the reactive precursors, which includes N₂ or rare gases.

The above mentioned preparation method of high density ZnO nanodots, wherein, said inert gas diluted gaseous DEZn is obtained by mixing the saturated vapor pulse of DEZn and a certain flow rate pulse of inert gas in the ALD gas cylinder. Accordingly, the concentration of gaseous DEZn can be controlled by adjusting the pulse times of the saturated vapor of DEZn and the inert gas. The flow rate of the inert gas used for diluting DEZn is 200~600 sccm.

The above mentioned preparation method of high density ZnO nanodots, wherein, the method includes a number of reaction cycles, and each reaction cycle further includes the following steps:
Step 1, the inert gas is firstly pulsed into the ALD gas cylinder, and then the saturated DEZn vapor is pulsed into the same gas cylinder during the inert gas pulse. Subsequently, the mixture of both gaseous DEZn and inert gas is pulsed into the reaction chamber from the gas cylinder. In order to make the gaseous DEZn and the inert gas mix fully, the pulse time of the inert gas is longer than that of the saturated DEZn vapor (0.2~0.5s).
Step 2, the inert gas is pulsed into the reaction chamber to purge the residual gaseous DEZn and other reaction by-products. The purging process stops when the pressure in the reaction chamber recovers to the minimal value.
Step 3, the vapor of H₂O₂ solution is pulsed into the reaction chamber. In order to ensure complete reaction of the adsorbed DEZn with the H₂O₂ vapor, the H₂O₂ pulse time is nearly equal to the pulse time of inert gas used for diluting the DEZn.
Step 4, the inert gas is pulsed into the reaction chamber to purge the residual H₂O₂ vapor and reaction by-products. The purging process stops when the pressure in the reaction chamber recovers to the minimal value.

The above mentioned preparation method of high density ZnO nanodots, wherein, the method also includes the following step: before Step 1, a substrate is loaded onto the substrate holder in the ALD reaction chamber.

The above mentioned preparation method of high density ZnO nanodots, wherein, said substrate is a monocrystalline Si wafer cleaned with the standard RCA process.

The above mentioned preparation method of high density ZnO nanodots, wherein, said substrate is a monocrystalline Si wafer cleaned with the standard RCA process, followed by thermal growth of a uniform and dense SiO₂ film on it.

The above mentioned preparation method of high density ZnO nanodots, wherein, said substrate is a monocrystalline Si wafer cleaned with the standard RCA process, followed by ALD growth of a uniform and dense Al₂O₃ film on it.

The above mentioned preparation method of high density ZnO nanodots, wherein, said pressure in the ALD reaction chamber is 100~500Pa, the substrate temperature is 200~400 °C and the flow rate of inert gas used for diluting DEZn is 200~600sccm.

In the present invention, the gaseous DEZn is diluted with the inert gas, which aims to reduce the concentration of DEZn in the reaction chamber. Therefore, this can result in the adsorption of gaseous DEZn at some specific sites on the substrate surface, and further reduce the density of nucleation sites. Accordingly, ZnO grows in the form of discrete nanodots rather than a continuous film.

The present invention adopts ALD technology to form two dimensional distributed ZnO nanodots spontaneously on the surface of monocrystalline silicon or dielectric films (for example, SiO₂ film) at low temperatures (200-400°C) without any post-treatment. The ZnO nanodots grown by the above method have the advantages of high density, small size, uniform size distribution, good compatibility with the process of photovoltaic devices.

In the present invention, the characteristics of the resulting ZnO nanodots and the advantages of the preparation method are as follows:
1) The present invention adopts the ALD technology to grow ZnO nanodots, which has the advantages of simple process and low costs in comparison with the chemical synthesis methods difficult to be used in the practical applications, and the physical methods suffering from high process temperatures.
2) The ALD technology adopted in the present invention is a low temperature process and can be compatible with the present CMOS fabrication technology. The ALD materials have good conformality, the sizes of ALD nanodots can be controlled accurately.
3) The formed ZnO nanodots in the present invention are small, whose transverse diameters are 5~25 nm, and whose heights are 2~10 nm.
4) The formed ZnO nanodots in the present invention exhibit a high density, uniform sizes and surface distribution, and its density is in a range of 1.0×10¹⁰~1.0×10¹¹ cm⁻².

### Brief Description of the Drawings

FIG. 1 shows a schematic diagram of the ALD system used to deposit ZnO nanodots.
FIG.2 shows the pulse times of DEZn and H₂O₂ for one reaction cycle as well as the purge time.
FIG. 3 is the AFM (Atomic Force Microscopy) picture of the high density ZnO nanodots on the Si substrate after 50 reaction cycles.
FIG. 4 is the AFM picture of the high density ZnO nanodots on the thermal oxidized SiO₂ substrate after 100 reaction cycles.

### Detailed Description of the Embodiments

The present invention is described hereinafter by way of example with reference to the accompanying drawings.

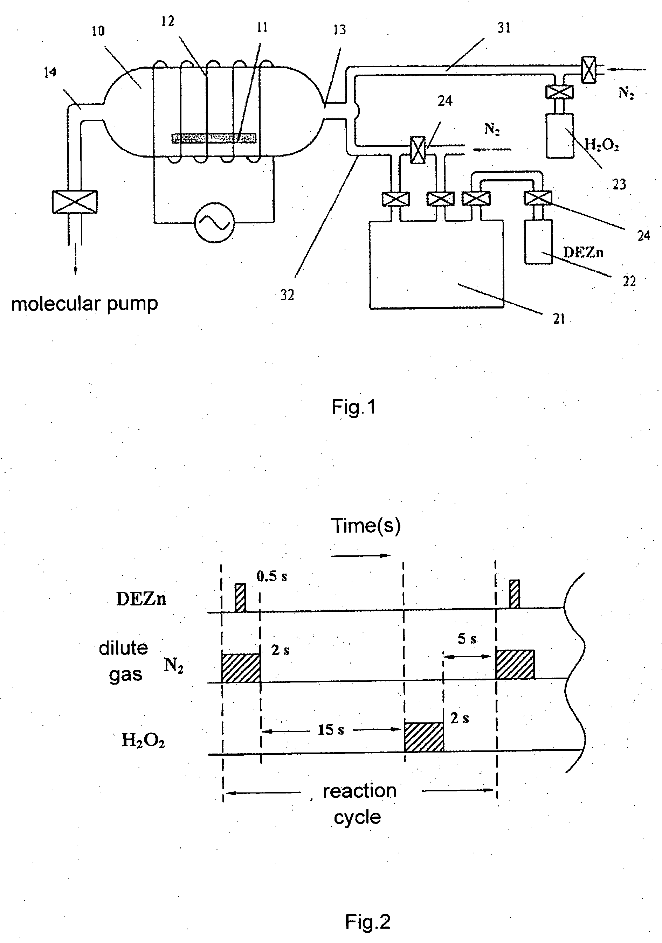

In this invention, high density ZnO nanodots are grown in the ALD reactor by using the precursors of N₂-dilluted DEZn and H₂O₂ (40% in H₂O). The schematic diagram of ALD reactor is shown in FIG. 1, which consists of a reaction system and a gas mixing system. Said reaction system includes a reaction chamber 10, a substrate holder 11 inside the reaction chamber 10 and a heater coil 12 outside the reaction chamber 10. The reaction chamber 10 further includes an inlet 13 connecting with the gas mixing system by a tube, and an outlet 14 connecting with a molecular pump by another tube. The above mentioned gas mixing system further includes a gas cylinder 21 used for diluting gaseous DEZn, a DEZn container 22 and a H₂O₂ container 23. The gas cylinder 21 is connected with the DEZn container 22 by a tube.

The inlet 13 connects the reaction chamber with two gas lines of precursors or inert gas. The first tube 31 is connected with the H₂O₂ container 23, the second tube 32 is connected with the gas cylinder 21. Moreover, the tube 32 is equipped with a valve 24 as a switching of inert gas pulse. All of the above mentioned tubes are equipped with a valve to control different gas lines.

The above mentioned substrate 11 can be changed in different example, which is a monocrystalline Si wafer cleaned with the standard RCA process, or a monocrystalline Si wafer cleaned with the standard RCA process, followed by the thermal growth of a uniform and dense SiO₂ film on it, or a monocrystalline Si wafer cleaned with the standard RCA process, followed by ALD growth of a uniform and dense Al₂O₃ film on it.

### Embodiment

At the beginning of the process, the gaseous DEZn is firstly diluted in the gas cylinder 21 with N₂, and then the N₂-diluted gaseous DEZn and H₂O₂ vapor were alternately pulsed into the ALD reaction chamber 10. The reactive precursors are not pulsed into the reaction chamber until the pressure is pumped down to 200Pa. The deposition temperature in the reaction chamber 10 is maintained at 300°C by the heater coil 12. The substrate 11 used for growth of high density ZnO nanodots is a monocrystalline Si wafer cleaned with the standard RCA process. The flow rate of N₂ for diluting gaseous DEZn is 400 standard cubic centimeter per min (sccm).

FIG. 2 shows the pulse times of DEZn and H₂O₂ for one reaction cycle as well as the purge time. Step 1, N₂ is pulsed into the gas cylinder 21 for 2s, and then the saturated DEZn vapor is pulsed into the same gas cylinder for 0.5s during the N₂ pulse. Subsequently, the gaseous mixture of both DEZn and N₂ is pulsed into the reaction chamber from the gas cylinder 21. Using the N₂-diluted DEZn can result in the absorption of gaseous DEZn at some special sites on the Si surface, which will favor the growth of ZnO islands. Step 2, N₂ is pulsed into the reaction chamber for 15s in order to purge the residual gaseous DEZn and reaction by-products. The reaction chamber is pumped down till the pressure inside recovers to the minimal value. Step 3, to ensure complete reaction of the adsorbed DEZn on the Si surface in the reaction chamber with H₂O₂ vapor, the H₂O₂ vapor is pulsed into the reaction chamber for 2s. Step 4, N₂ is pulsed into the reaction chamber for 5s to purge the residual H₂O₂ vapor and reaction by-products, and the reaction chamber is pumped down till the pressure inside recovers to the minimal value. At the moment, one reaction cycle has been finished, and then the next reaction cycle will begin by repeating the above mentioned steps. The said pulse times are controlled by the ALD system, and depend on the switching times of the corresponding valves. The pump is always working during the whole ALD process.

The pressure in the reaction chamber usually increases owing to the input of the reactive precursors during the reaction cycles, especially, when the carrier gas is introduced. Therefore, the residual reactive precursors need be purged by an inert gas after a reactive precursor pulse. During the purging process, the reaction chamber is pumped down to a low pressure, thus the above mentioned minimal pressure is a dynamic balance value, which depends on the flow rate of the inert gas, the power of the pump, the temperature in the reaction chamber and the volume of the reaction chamber. The said minimal pressure is an experimental parameter and does not have a constant criterion. The minimal pressure in the reaction chamber is usually maintained below several hundred Pascal.

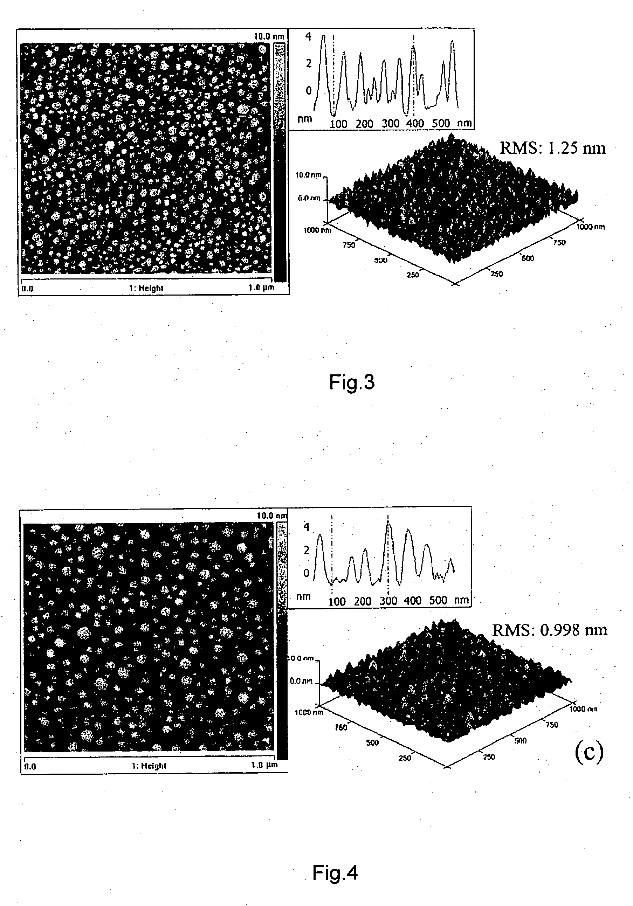

The high density ZnO nanodots are formed on the Si wafer after 50 cycles, the corresponding AFM picture is shown in FIG. 3. The density of ZnO nanodots is about 1×10¹¹ cm⁻², the corresponding mean transverse diameter and height equal 15nm and 5nm, respectively. The said transverse diameter can be observed directly in FIG. 3, while the height can be obtained indirectly from the height bar in the right side according to the clair-obscure of color. The above mentioned parameters can be calculated by the special software equipped with the AFM.

The AFM picture of the ZnO nanodots grown on the thermal oxidized SiO₂ substrate after 100 reaction cycles is shown in FIG. 4. The density of the resulting ZnO nanodots is about 5×10¹⁰ cm⁻², and the corresponding mean transverse diameter and height are 25 nm and 4 nm, respectively.

In this invention, the ALD growth of high density ZnO nanodots on Si wafer or processed Si wafer has been realized by using the inert gas diluted gaseous DEZn and H₂O₂ vapor as reactive precursors. The mean transverse diameter and height of the resulting ZnO nanodots are 5~25nm and 2~10 nm, respectively, and its density is in a range of 1.0×10¹⁰~1.0×10¹¹ cm⁻².

## Claims

1. A method for preparing high-density ZnO nanodots by atomic layer deposition (ALD), the method comprising growing high density ZnO nanodots, by alternately pulsing inert gas diluted gaseous diethyl zinc (DEZn) and H₂O₂ vapor as reactive precursors into an ALD reaction chamber, and introducing inert gas as a purge gas during the interval between said two precursor pulse; wherein said inert gas diluted gaseous DEZn is obtained by injecting saturated vapor of DEZn and a certain flow rate of inert gas into an ALD gas cylinder, respectively, and controlling the concentration of gaseous DEZn by adjusting the pulse times of DEZn and the inert gas; wherein the flow rate of the inert gas used for diluting DEZn is 200~600sccm.

2. The method of claim 1, wherein the inert gas does not react with the reactive precursors, including N₂ or rare gases.

3. The method of claim 1, wherein the method comprises a number of reaction cycles, and each reaction cycle includes the following steps,
step 1, pulsing an inert gas into a gas cylinder, followed by pursing a saturated vapor of DEZn into the same gas cylinder during inert gas pulse, and pulsing the mixture of the gaseous DEZn and H₂O₂ vapor into the reaction chamber from the gas cylinder in order to ensure full mixing of both gaseous DEZn and inert gals, wherein the pulse time of the inert gas is longer than that of the gaseous DEZn, and the pulse time of the DEZn is 0.2~0.5s;
step 2, using the inert gas to purge residual gaseous DEZn and reaction by-products, wherein the purging process is stopped when the pressure in the reaction chamber recovers to the minimal value;
step 3, introducing H₂O₂ vapor into the reaction chamber in order to ensure the complete reaction of the adsorbed DEZn on a sample surface in said reaction chamber with the H₂O₂ vapor, wherein the H₂O₂ pulse time is nearly equal to the pulse time of the inert gas used for diluting the gaseous DEZn; and
step 4, using the inert gas to purge the residual H₂O₂ vapor and reaction by-products, wherein the purging process is stopped when the pressure in the reaction chamber recovers to minimal value.

4. The method of claim 3, wherein the method further comprises the following step: before step 1, a substrate is loaded onto a substrate holder in the ALD reaction chamber.

5. The method of claim 4, wherein said substrate is a monocrystalline Si wafer cleaned with the standard RCA process.

6. The method of claim 4, wherein said substrate is a monocrystalline Si wafer cleaned with the standard RCA process, followed by thermal growth of a uniform and dense SiO₂ film on it.

7. The method of claim 4, wherein said substrate is a monocrysalline Si wafer cleaned with the standard RCA process, followed by the ALD growth of a uniform and dense Al₂O₃ film on it.

8. The method of claim 4, wherein the pressure in the ALD reaction chamber is 100~500Pa, the process temperature is about 200~400°C.

## Patentansprüche

1. Verfahren zur Herstellung von ZnO-Nanopunkten hoher Dichte durch Atomlagenabscheidung (ALD), wobei das Verfahren das Wachsenlassen von ZnO-Nanopunkten hoher Dichte durch abwechselndes Pulsierenlassen von mit Inertgas verdünntem gasförmigen Diethylzink (DEZn) und H₂O₂-Dampf als reaktive Vorläufer in eine ALD-Reaktionskammer und das Einführen von Inertgas als Spülgas während des Zeitraums zwischen den beiden Vorläuferpulsen umfasst; wobei das mit Inertgas verdünnte gasförmige DEZn dadurch erhalten wird, dass man gesättigten Dampf von DEZn und Inertgas mit einer bestimmten Strömungsgeschwindigkeit in eine ALD-Gasflasche einspritzt und die Konzentration des gasförmigen DEZn durch Einstellen der Pulszeiten von DEZn und des Inertgases steuert; wobei die Strömungsgeschwindigkeit des zur Verdünnung von DEZn verwendeten Inertgases 200 bis 600 Standardkubikzentimeter pro Minute (sccm) beträgt.

2. Verfahren gemäß Anspruch 1, wobei das Inertgas nicht mit den reaktiven Vorläufern einschließlich N₂ oder Edelgasen reagiert.

3. Verfahren gemäß Anspruch 1, wobei das Verfahren eine Anzahl von Reaktionszyklen umfasst und jeder Reaktionszyklus die folgenden Schritte umfasst:
Schritt 1: Pulsierenlassen eines Inertgases in eine Gasflasche und anschließendes Pulsierenlassen eines gesättigten Dampfes von DEZn in dieselbe Gasflasche während des Inertgaspulses und Pulsierenlassen des Gemischs aus dem gasförmigen DEZn und H₂O₂-Dampf aus der Gasflasche in die Reaktionskammer, um ein vollständiges Mischen sowohl von gasförmigem DEZn als auch von Inertgas zu gewährleisten, wobei die Pulszeit des Inertgases länger ist als die des gasförmigen DEZn und die Pulszeit des DEZn 0,2 bis 0,5 s beträgt;
Schritt 2: Verwenden des Inertgases zum Ausspülen von restlichem gasförmigen DEZn und von Reaktionsnebenprodukten, wobei der Spülvorgang abgebrochen wird, wenn der Druck in der Reaktionskammer zum Minimalwert zurückgekehrt ist;
Schritt 3: Einführen von H₂O₂-Dampf in die Reaktionskammer, um eine vollständige Reaktion des adsorbierten DEZn auf einer Probenfläche in der Reaktionskammer mit dem H₂O₂-Dampf zu gewährleisten, wobei die H₂O₂-Pulszeit fast gleich der Pulszeit des zum Verdünnen des gasförmigen DEZn verwendeten Inertgases ist; und
Schritt 4: Verwenden des Inertgases zum Ausspülen des restlichen H₂O₂-Dampfes und von Reaktionsnebenprodukten, wobei der Spülvorgang abgebrochen wird, wenn der Druck in der Reaktionskammer zum Minimalwert zurückgekehrt ist.

4. Verfahren gemäß Anspruch 3, wobei das Verfahren weiterhin den folgenden Schritt umfasst: vor Schritt 1 wird ein Substrat auf einen Substrathalter in der ALD-Reaktionskammer geladen.

5. Verfahren gemäß Anspruch 4, wobei das Substrat ein einkristalliner Si-Wafer ist, der mit dem Standard-RCA-Verfahren gereinigt ist.

6. Verfahren gemäß Anspruch 4, wobei das Substrat ein einkristalliner Si-Wafer ist, der mit dem Standard-RCA-Verfahren gereinigt ist, wobei anschließend thermisches Wachstum einer gleichmäßigen und dichten SiO₂-Schicht auf demselben erfolgt ist.

7. Verfahren gemäß Anspruch 4, wobei das Substrat ein einkristalliner Si-Wafer ist, der mit dem Standard-RCA-Verfahren gereinigt ist, wobei anschließend ALD-Wachstum einer gleichmäßigen und dichten Al₂O₃-Schicht auf demselben erfolgt ist.

8. Verfahren gemäß Anspruch 4, wobei der Druck in der ALD-Reaktionskammer 100 bis 500 Pa beträgt und die Verfahrenstemperatur etwa 200 bis 400 °C beträgt.

## Revendications

1. Procédé de préparation de nano pastilles de ZnO haute densité par dépôt par couches atomiques (ALD), ce procédé comprenant des étapes consistant à faire croître des nano pastilles de ZnO haute densité par pulsation alternative de diéthyl zinc (DEZn) gazeux dilué dans un gaz inerte et de vapeur de H₂O₂ en tant que précurseurs réactifs dans une chambre de réaction ALD et à introduire un gaz inerte en tant que gaz purgeur dans l'intervalle entre deux impulsions de précurseurs, le DEZn gazeux dilué dans un gaz inerte étant obtenu en injectant respectivement de la vapeur saturée de DEZn et un débit donné de gaz inerte dans un cylindre à gaz ALD, et en commandant la concentration en DEZn gazeux en réglant la durée d'impulsion du DEZn et de gaz inerte, le débit de gaz inerte utilisé pour diluer le DEZn étant de 200-600 sccm.

2. Procédé conforme à la revendication 1,
selon lequel le gaz inerte ne réagit pas avec les précurseurs réactifs, y compris N₂ ou des gaz rares.

3. Procédé conforme à la revendication 1,
comprenant plusieurs cycles de réaction, chaque cycle de réaction comprenant les étapes suivantes :
étape 1 : pulser un gaz inerte dans un cylindre à gaz puis pulser de la vapeur saturée de DEZn dans le même cylindre à gaz au cours de la pulsation de gaz inerte et pulser le mélange de DEZn gazeux et de vapeur de H₂O₂ dans la chambre de réaction à partir du cylindre à gaz pour garantir le mélange complet du DEZn gazeux et du gaz inerte, la durée de pulsation du gaz inerte étant plus longue que celle du DEZn gazeux, et la durée de pulsation du DEZn étant de 0,2-0,5 s ;
étape 2 : utiliser le gaz inerte pour purger le DEZn gazeux résiduel et les sous-produits réactionnels, le processus de purge étant arrêté lorsque la pression dans la chambre de réaction retrouve sa valeur minimum,
étape 3 : introduire de la vapeur de H₂O₂ dans la chambre de réaction pour garantir la réaction complète du DEZn adsorbé sur une surface échantillon dans la chambre de réaction avec la vapeur de H₂O₂, la durée de pulsation de H₂O₂ étant approximativement égale à la durée de pulsation du gaz inerte utilisé pour diluer le DEZn gazeux, et
étape 4 : utiliser le gaz inerte pour purger la vapeur de H₂O₂ résiduelle et les sous-produits réactionnels, le procédé de purge étant arrêté lorsque la pression dans la chambre de réaction a retrouvé sa valeur minimum.

4. Procédé conforme à la revendication 3,
comprenant, en outre, l'étape consistant à charger, avant l'étape 1, un substrat sur un porte-substrat dans la chambre de réaction ALD.

5. Procédé conforme à la revendication 4,
selon lequel le substrat est une tranche de Si mono cristallin purifiée par le procédé RCA standard.

6. Procédé conforme à la revendication 4,
selon lequel le substrat est une tranche de Si mono cristallin purifiée par le procédé RCA standard suivie par la croissance thermique sur celle-ci d'un film de SiO₂ uniforme et dense.

7. Procédé conforme à la revendication 4,
selon lequel le substrat est une tranche de Si mono cristallin purifiée par le procédé RCA standard suivie par la croissance ALD sur celle-ci d'un film de Al₂O₃ uniforme et dense.

8. Procédé conforme à la revendication 4,
selon lequel la pression dans la chambre de réaction ALD est de 100-500 Pa, et la température de procédé est de l'ordre de 200-400°C.
